# EUROPEAN PATENT APPLICATION

(11) **EP 4 312 040 A1**
(43) Date of publication of application: **31.01.2024**
(21) Application number: 22186896.1
(22) Date of filing: 26.07.2022
(51) Int. Cl.: G01R 33/28

(54) **SPECIFIC ABSORPTION RATE (SAR) REDUCTION PAD, MAGNETIC RESONANCE IMAGING (MRI) SYSTEM AND METHOD FOR OPERATING AN MRI SYSTEM**

(71) Applicant: Koninklijke Philips N.V., 5656 AG Eindhoven (NL)
(72) Inventor: LEUSSLER, Christoph Günther, Eindhoven (NL); LIPS, Oliver, Eindhoven (NL); PREVRHAL, Sven Peter, 5656AG Eindhoven (NL)
(74) Representative: Philips Intellectual Property & Standards

(57) **Abstract**

The invention relates to a specific absorption rate, SAR, reduction pad (1). The SAR reduction pad (1) comprises a pad body (2), a first surface (3), arranged on one side of the pad body (2), a second surface (4), arranged on another side of the pad body (2), opposite to the first surface (3) and distance generation means (5, 6; 7). The distance generation means (5, 6; 7) are adapted to increase a distance between the first surface (3) and the second surface (4). The invention further relates to a magnetic resonance imaging, MRI, system (16), comprising MRI electronics, a computing unit (22) and at least one specific absorption rate, SAR, reduction pad (1) according to the above description. The invention also relates to a method for operating a magnetic resonance imaging, MRI, system (16).

## Description

### FIELD OF THE INVENTION

The invention relates to a specific absorption rate (SAR) reduction pad, to a magnetic resonance imaging (MRI) system comprising a SAR reduction pad and to a method for operating an MRI system.

### BACKGROUND OF THE INVENTION

Magnetic resonance imaging (MRI) deposits electromagnetic (EM) energy into the patient's body which can cause local heating and is thus a burn hazard. The measure of the amount of power deposited by a radiofrequency field in a certain mass of tissue is the specific absorption rate (SAR).

In particular, radio frequency (RF) burns can occur when a part of the body comes in contact with high electric fields and at the same time sufficient cooling is not available. This is often the case when large parts of the body touch the inner wall of the MR bore. At such positions there can be high electric fields, since the wall is in the vicinity of the RF body coil capacitors. Furthermore, the surrounding air flow that would normally provide cooling to such heated skin areas is blocked. As a mitigation, e.g., padding with dry towels may be proposed. This, however, still substantially hampers air flow. Furthermore, it is difficult to place the padding correctly once the patient is already in the bore, which is however necessary to spot the problematic locations. Consequently, this situation is still a typical failure mode for the reported RF burns.

Also, dielectrical pads may be manually placed to shield the body from the EM fields around metallic hardware such as MR coils and cabling. However, the actual efficacy of this precaution during the exam is not known.

Furthermore, proper patient positioning is highly human-dependent: among other tasks, clinic tech staff must manually interact with the patient and the scanner to minimize superficial heating due to local variation of SAR values and ensure safe routing of cables such as coil leads and other metallic objects that are either connected to the patient or routed on top of the patient's body. Where areas with predictably high SAR values are known, the above-mentioned dielectric pads for reducing SAR can be manually placed. Furthermore, the patient must be monitored throughout the scan for reactions that may indicate elevated local heating, such as cries of pain or quick involuntary body shifts. However, sedated, impaired or ill-informed patients may not feel or report elevated heating, which may cause mild burns or even long-term skin and tissue damage.

Moreover, local MRI coils such as head, neck, carotid, or shoulder coils are difficult to position and need to be individually adapted by an experienced operator. Wrong or no positioning of dielectric pads leads to a compromise of accepted SAR, loss of image quality and discomfort or pain for the patient, which needs to be monitored throughout the exam. In many instances, the coil and SAR padding may only be bearable for a short while, but then need to be removed or repositioned due to patient discomfort. The corresponding interruptions of the exam extend exam time with further potential negative consequences with respect to patient comfort, cost, and throughput rate.

### SUMMARY OF THE INVENTION

It is therefore an object of the present invention to provide a specific absorption rate (SAR) reduction pad, a magnetic resonance imaging (MRI) system and a method for operating an MRI system that feature an improved protection for a patient from local overheating and/or burns.

The object of the present invention is solved by the subject matter of the independent claims, wherein further embodiments are incorporated in the dependent claims.

In an aspect of the present invention, a specific absorption rate (SAR) reduction pad is provided. In particular, said SAR reduction pad is intended for use with a magnetic resonance imaging (MRI) system. The SAR reduction pad shall prevent overheating and/or burns of a patient's skin and/or tissue, caused by locally high electromagnetic (EM) fields produced by the MRI system and/or by hot parts of MRI electronics such as coils, cables and/or capacitors. Sources for overheating and/or burns of the patient's skin and/or tissue may be local field hotspots of transmitting radio frequency (RF) coils, local overheating of RF connecting cables or RF traps, malfunctioning of detuning circuits, de-soldering of capacitors or wrong shimming when operating the MRI system.

The SAR reduction pad comprises a pad body, a first surface and a second surface. The first surface is arranged on one side of the pad body and the second surface is arranged on another side of the pad body, opposite to the first surface. In particular, a shape of the first surface may be similar to a shape of the second surface and a distance between the first surface and the second surface may be shorter than the dimensions of the first and/or second surface. Also, the first surface may be, at least partially, adjacent to the second surface. Alternatively, and/or additionally, there may be side surfaces connecting the first surface and the second surface.

The SAR reduction pad further comprises distance generation means to increase the distance between the first surface and the second surface. By increasing the distance between the first surface and the second surface, a distance between the patient and the MRI electronics, between the patient and an inner wall of the MRI system and/or between the patient and a locally high EM field may be increased. For a SAR reduction pad placed between the patient and the MRI electronics and/or between the patient and the inner wall of the MRI system, the distance between the first surface and the second surface may increase by at least 5 mm, up to 15 mm. Also, the distance between the first surface and the second surface may be increased only partially, i.e., only by a part of the maximal possible value.

The SAR reduction pad moves, when the distance between the first surface and the second surface has been increased, the patient away from locally high EM fields, MRI electronics and/or inner walls of the MRI system and therefore reduces the specific absorption rate and hence the risk for overheating and/or burns of the patient's skin and/or tissue. On the other hand, when the distance between the first surface and the second surface is not increased, the SAR reduction pad does not require much space and hence placement options, in particular of the patient, are not or only slightly limited by the SAR reduction pad. Also, when the distance between the first surface and the second surface is not increased, there may remain more free space inside a bore of the MRI system.

According to an embodiment, the distance generation means comprise at least one chamber to be filled with a fluid and at least one fluid inlet that is in fluid connection with the at least one chamber. Hence, the distance between the first surface and the second surface may be increased by letting in a fluid through the at least one fluid inlet into the at least one chamber such that the size of the chamber increases. The at least one chamber may be arranged between the first surface and the second surface, such that said increase in the size of the chamber moves the second surface away from the first surface, increasing the distance between the first surface and the second surface. The fluid may be a liquid or a gas, in particular air or another non-dangerous gas. The fluid may be let into the at least one chamber at a high pressure such that the distance between the first surface and the second surface may be rapidly increased and hence the patient's skin and/or tissue may be protected from overheating and/or burns. There may be one chamber per SAR reduction pad or a plurality of chambers, e.g., air cushions, per SAR reduction pad. If there are two or more chambers per SAR reduction pad, the separate chambers may be in fluid connection to one another and/or may be in fluid connection with separate fluid inlets. If the separate chambers are not in fluid connection to one another and are in fluid connection with separate fluid inlets, they may be separately inflated, e.g., such that the distance between the first surface and the second surface is only increased at certain locations.

According to an embodiment, the distance generation means comprises at least one valve arranged between the at least one fluid inlet and the at least one chamber. Hence, when the fluid is supplied to the at least one fluid inlet, opening the at least one valve may make a fluid connection from the fluid inlet to the chamber and hence the chamber may be filled with the fluid. As an example, the SAR reduction pad may comprise one fluid inlet and a plurality of valves, wherein each valve is connected to a chamber. Opening only some of the valves will lead to an inflation of only those chambers that are connected to the opened valves, whereas the other chambers will stay in a deflated state. That is, an individual inflation of single air cushions is provided and hence, an increase in the distance between the first surface and the second surface will only take place at locations where the inflated chambers are arranged.

According to an embodiment, the distance generation means further comprise at least one fluid outlet in fluid connection with the at least one chamber for circulating the fluid through the at least one chamber. By letting the fluid enter the chamber via the at least one fluid inlet and exit the chamber via the at least one fluid outlet, a flow of the fluid is generated, which may, in particular, provide cooling, more particularly to the skin of the patient. As an example, the SAR reduction pad may be realized with the fluid inlet and the fluid outlet on opposing sides of the SAR reduction pad. Alternatively, the chamber may be a U-shaped cushion or tube such that the fluid inlet and the fluid outlet are on one side of the SAR reduction pad. The necessary flow of the fluid, e.g., the necessary air flow, can be generated easily by known means, e.g., in a technical room associated with the MRI system. The fluid can then be straightforwardly directed via plastic tubes through waveguides into a magnet room of the MRI system. By controlling valves, in particular valves between the fluid inlet and the chamber as well as valves between the chamber and the fluid outlet, both the flow of the fluid and the degree of inflation of the chamber can be controlled.

According to an embodiment, the distance generation means comprise at least one mechanical distance generator. An example for such a mechanical distance generator is a folding strip that may be attached at its one end to the first surface and at its second end to the second surface. The folding strip may be in a folded state and may be unfolded when the distance between the first surface and the second surface is to be increased. Such unfolding may be performed, e.g., by actuating a motor or by pulling an auxiliary strip that is attached to a center position of the folding strip. As another example, the mechanical distance generator may comprise bolts and/or threaded rods that are guided through the first surface of the SAR reduction pad and are in contact with the second surface of the SAR reduction pad. The bolts and/or threaded rods may then be actuated, e.g., screwed, from the outside to push the second surface away from the first surface and hence increase the distance between the first surface and the second surface.

According to an embodiment, the SAR reduction pad further comprises at least one sensor. Said sensor may be a pressure sensor, e.g., a sensor measuring a force between the first surface and the second surface. The pressure sensor may be a known pressure sensor. Also, the pressure sensor may be a flow sensor, measuring the flow resistance of the fluid flowing through the chamber of the SAR reduction pad. The higher the pressure exerted on the SAR reduction pad, the higher the flow resistance, the value of which can then be used to infer the pressure. As an example, said pressure may be exerted on the SAR reduction pad by a patient's arm touching an inner bore wall of the MRI system. The sensor may also be an electromagnetic field sensor, in particular adapted to sense high EM fields that may lead to local overheating and/or burns of the patient's skin and/or tissue. The sensor may also be a temperature sensor. In particular when the SAR reduction pad is close to or in contact with the patient's skin, an increase in temperature measured by the temperature sensor may indicate an overheating of the patient's skin and/or tissue. The sensor may also be a distance sensor, such as an ultrasound, radar, lidar and/or optical sensor, directly measuring a distance between the SAR reduction pad and a part of the MRI system generating an EM field and/or a distance between the patient's skin and a part of the MRI system generating an EM field.

According to an embodiment, the SAR reduction pad further comprises an electrical, electronical, optical and/or wireless connector. The electrical and/or electronical connector may provide a wired connection, e.g., a low-voltage differential signaling (LVDS) digital data connection, to another SAR reduction pad and/or to a computing unit of the MRI system. Likewise, the optical connector may provide an optical data connection to another SAR reduction pad and/or to a computing unit of the MRI system via an optical fiber. A wireless data connection can also be established to another SAR reduction pad and/or to a computing unit of the MRI system. As an example, several SAR reduction pads may be connected to one another via an LVDS or optical data connection and one of the SAR reductions pads is further connected wirelessly to the computing unit of the MRI system. Said wirelessly connected SAR reduction pad distributes data received from the computing unit to the other SAR reduction pads and collects data from the other SAR reduction pads to be sent to the computing unit. Data received from the computing unit may include valve control data and/or mechanical distance generator instructions and data to be sent to the computing unit may include sensor readings from the sensors of the SAR reduction pads.

In another aspect of the present invention, a magnetic resonance imaging (MRI) system is provided. The MRI system comprises MRI electronics, a computing unit and at least one SAR reduction pad according to the above description.

The MRI electronics includes at least one out of a transmitting coil for transmitting radio frequency (RF) signals, a receiving coil for receiving RF signals, a transmitting/receiving coil for transmitting and receiving RF signals, cables and capacitors. The cables may be cables connecting the RF coils. Said MRI electronics may be a source for overheating and/or burns of a patient's skin and/or tissue, e.g., due to local field hotspots of the transmitting RF coils, local overheating of the RF connecting cables or RF traps, malfunctioning of detuning circuits and/or de-soldering of the capacitors.

The computing unit may be a local computing unit of the MRI system but may also be remotely installed, e.g., cloud based. It may be a single unit or comprise several connected computing devices. Parts of the computing unit may even be integrated in the at least on SAR reduction pad.

If there are two or more SAR reduction pads, they may be interconnected to a large assembly, with additional interconnect devices that provide mechanical, electrical, electronical and/or optical linkage between the SAR reduction pads. Some of the SAR reduction pads may also comprise a wireless transceiver to exchange data with the computing unit, to transmit sensor data and the receive control data. The SAR reduction pads that are equipped with the wireless transceiver may pool data from other SAR reduction pads via the electronical and/or optical connection and transmit the pooled data to the computing unit. Likewise, the SAR reduction pads with the wireless transceiver may receive data from the computing unit and then distribute it to the other SAR reduction pads via the electronical and/or optical connection.

According to an embodiment, the at least one SAR reduction pad is attached to a bore wall of the MRI system, in particular to a side of the bore wall. Here, the bore may be an open bore or a closed bore and refers to the cavity into which the patient or part of the patient to be examined is placed for the examination. Several options are possible, e.g., one or more SAR reduction pads covering the entire bore wall, or one or more SAR reduction pads arranged at a side of the bore wall, e.g., to the left and the right of the patient. Since the SAR reduction pads do not require much space when the distance between the first surface and the second surface is not increased, they may remain inside the bore without significantly hampering the workflow. When they are needed, however, they are always positioned at the correct place. Alternatively, the SAR reduction pads may be detachable and may be applied temporarily as an accessory, if needed.

Alternatively, or additionally, the at least one SAR reduction pad constitutes at least a part of the bore wall of the MRI system. Mechanical stability of the bore may be provided by a frame and a thickness of a solid bore wall may be reduced or the solid bore wall may be completely omitted. Hence, the size of the bore may be increased, in comparison to a regular solid bore wall by, e.g., 1.5 cm in diameter. The SAR reduction pad(s) may then be considered as an adjustable bore wall, which can be adapted to the patient inside the bore and/or to details of the MRI scans. For example, the distance between the first surface and the second surface may be increased where the patient might touch the bore and/or come too close to the coils and the distance between the first surface and the second surface may stay small where there is no need for a thick bore wall, thus preserving space. Also, when the distance between the first surface and the second surface is small, bigger patients may be scanned and/or claustrophobic feelings may be reduced due to the gained free space.

Alternatively, or additionally, the at least one SAR reduction pad is placed on at least one part of the MRI electronics, for example around a cable. If needed, the distance between the cable and its surroundings, in particular the patient, can be increased by increasing the distance between the first surface and the second surface of the SAR reduction pad. In the case of a cylindrical SAR reduction pad, the first surface may be an inner surface and the second surface may be an outer surface, or vice versa.

Alternatively, or additionally, the at least one SAR reduction pad is attached to the patient. For example, the SAR reduction pads may be attached to clothes of the patient. By increasing the distance between the first surface and the second surface of the SAR reduction pad, the patient's skin and/or tissue may be moved further away from a source of overheating, e.g., from a locally strong EM field and/or from a hot part of the MRI electronics.

According to an embodiment, the MRI system further comprises a user interface and the computing unit is configured to determine a placement of the SAR reduction pads and to provide SAR reduction pad placement instructions via the user interface. To determine the placement of the SAR reduction pads, the computing unit may use data relating to a position and/or pose of the patient and/or positions of the MRI electronics such as coils and cables, which may be obtained with radar sensors, lidar sensors and/or an optical positioning detection unit that comprises at least one, preferably two or more, cameras. The placement of the SAR reduction pads may be further determined based on details of the MRI scans to be performed, such as which body parts are to be scanned and/or the scheduled scan sequence. Also, patient characteristics such as age, size and/or weight but also sedation status, may be used to determine the placement of the SAR reduction pads. In particular, the placement of the SAR reduction pads is determined such that the SAR reduction pads are placed at locations where there is a risk for overheating and/or burns of the patient's skin and/or tissue. The placement instructions are then provided via the user interface, where the user interface may be a display that indicates the positions at which the SAR reduction pads are to be placed. With such placement instructions, the skill requirements for a user placing the SAR reductions pads are relatively low and the placing of the SAR reduction pads no longer depends on highly trained operator staff. Hence, an automation of the clinic workflow for MRI scans is possible without the need for highly trained users. Optionally, the SAR reduction pads may comprise identification means, such as color coding, icons and/or alphanumerical labels and these identification means are also displayed on the display. Then, the location of each of the separate SAR reduction pads is determined along with its identity, such that sensor readings from the SAR reduction pad can be assigned to the specific location of said SAR reduction pad and instructions, in particular to increase the distance between the first surface and the second surface, may be provided to the correct SAR reduction pad.

According to an embodiment, the computing unit is configured to selectively activate the distance generation means. Said selective activation may comprise only partially increasing the distance between the first surface and the second surface for some of the SAR reduction pads and/or some parts of the SAR reduction pads. In particular, the activation of the distance generation means is performed only where an increase in distance between the first surface and the second surface is needed to reduce the risk for overheating and/or burns. As an example, by selectively activating the distance generation means of SAR reduction pads that are attached to the inner bore wall and/or that constitute the inner bore wall, said inner bore wall is adapted to its required shape. Also, by selectively activating the distance generation means, a spatial configuration of active SAR reduction pads is created, optimizing the local specific absorption rate values for a specific MRI scan sequence and for the specific patient, such that the risk for overheating and/or burns is reduced. The activation of the distance generation means itself depends on details of the SAR reduction pads. As an example, chambers may be inflated by letting air flow to the fluid inlets connected to said chambers. As another example, mechanical distance generators may be activated by sending electric and/or electronic impulses to them or wirelessly, e.g., via a transmit field of an RF coil, in particular along with an RF rectification to control an electronic on/off switch. Similarly, valves can opened and/or closed such that the fluid may fill up a chamber. Further, both valves connected to the fluid inlet and valves connected to the fluid outlet may be controlled in order to control both the level of inflation of the chamber and the flow of the fluid, wherein a flow of the fluid provides additional cooling to the patient's skin and/or tissue. In particular, the activation of the distance generation means is based on sensor readings. Said sensors may be radar sensors, lidar sensors and/or an optical positioning detection unit that capture the patient's positioning and/or the positioning of MRI electronics such as cables and coils. Using said sensor reading, the computing unit identifies the locations that are most prone to overheating and/or burns and activates the distance generation means at said locations. The sensors may also be pressure sensors, in particular of the SAR reduction pad, that sense when, e.g., the patient touches the bore wall. The distance generation means corresponding to those locations where the most pressure is detected are then activated. Further, the sensors may be temperature and/or EM field sensors, in particular of the SAR reduction pad, that sense an actual increase in temperature and/or a locally strong EM field and lead to an activation of the respective distance generation means. In particular, the sensor readings are taken continuously, sent to the computing unit and used by the computing unit to selectively activate the distance generation means. Further, the sensor readings may be stored by the computing unit for later off-line analysis and, e.g., further improvement of the MRI system and/or the computing unit. For the selective activation of the SAR reduction pads, the computing unit may also take into account further data such as the planned MRI scanning sequence, the patient age, size and/or weight and the condition of the patient, e.g., his or her sedation status.

According to an embodiment, the computing unit is configured to issue an alert, modify an MRI scan sequence and/or stop an MRI scan based on the sensor readings. As an example, varying detected pressures may indicate a patient movement and lead to the issue of a patient alarm and/or a nurse call. As another example, the detection of high temperatures and/or of strong local EM fields may first lead to the activation of the distance generation means, as described above. If said activation of the distance generation means does not sufficiently reduce the temperatures and/or EM fields, the computing unit may modify the MRI scan sequence, e.g., by performing shorter scans, scans with a reduced EM field strength and/or scans that have a different spatial distribution of the EM fields. Alternatively, or if the modification of the MRI scan sequence has not lead to a sufficient decrease of temperatures and/or EM fields, the computing unit may completely stop the MRI scan to ensure patient safety.

According to an embodiment, the computing unit comprises an artificial intelligence system, in particular a trained machine learning system such as an artificial neural network. If the computing unit is configured to both determine the placement of the SAR reduction pads and to selectively activate the distance generation means, the computing unit may actually comprise two artificial intelligence systems, one for each of the tasks. The training of said artificial intelligence may be based on data taken in a clinical study of routine MRI exams where, e.g., elevated heating is monitored by vital sensing using, for example, optical and/or infrared cameras and/or smart pads comprising temperature and/or EM field sensors. In said clinical studies, the positioning of the SAR reduction pads is performed manually by a skilled operator, e.g., following a standard procedure. The output of a positioning detection unit and/or readings from both mobile and integrated smart pads, in particular SAR reduction pads, with EM field sensors, temperature sensors and/or location sensors such as a three-axis digital accelerometer and a three-axis digital gyroscope, are gathered. These data, together with MRI characteristics such as machine type and imaging sequence as well as patient characteristics such as age, size, weight, anaesthesia/sedation status and/or pediatric status are used as input to train the artificial intelligence, in particular the neural network.

Alternatively, in particular for the activation of the distance generation means, the computing unit may comprise a conventional algorithm that, e.g., activates the distance generation means when a predetermined threshold of an EM field value and/or a temperature value has been exceeded. In yet another aspect of the present invention, a method for operating a magnetic resonance imaging, MRI, system according to the above description is provided. According to the method, a placement of the SAR reduction pads is determined by the computing unit and said determined placement is provided to a user via the user interface. The SAR reduction pads are then placed by the user according to the determined placement of the SAR reduction pads. For this placement, a user with ordinary skills is sufficient and there is no need for a highly trained user with ample experience in placing SAR reduction pads. Also, by determining the placement of the SAR reduction pads with the computing unit, there is no need for a human evaluation of the patient and the planned MRI scan sequence which then results in placing the SAR reduction pads based on the experience of the highly trained user. Hence, the workflow of placing the SAR reduction pads is improved, in particular automated, simplified and accelerated. Once the SAR reduction pads have been placed, an MRI scan and/or a MRI scan sequence is performed. According to an embodiment, sensor readings are obtained before and/or during the MRI scan and/or the MRI scan sequence and the distance generation means are selectively activated based on the obtained sensor readings. This results in a reduction of the risk for overheating and/or burns of the patient's skin and/or tissue.

More details and advantages of the method for operating the magnetic resonance imaging system may be found in the above description, where the operation of the MRI system has been described along with the description of the MRI system itself.

It shall be understood that a preferred embodiment of the invention can also be any combination of the dependent claims with the respective independent claim.

These and other aspects of the invention will be apparent from and elucidated with reference to the embodiments described hereinafter.

### BRIEF DESCRIPTION OF THE DRAWINGS

In the following, preferred embodiments of the invention will be described, by way of example only, and with reference to the drawings in which:
Fig. 1a shows a schematic cross-section of an embodiment of a SAR reduction pad;
Fig. 1b shows a schematic cross-section of the SAR reduction pad of Fig. 1a in an activated state;
Fig. 2a shows a schematic cross-section of another embodiment of a SAR reduction pad;
Fig. 2b shows a schematic cross-section of the SAR reduction pad of Fig. 2a in an activated state;
Fig. 3a shows a schematic cross-section of yet another embodiment of a SAR reduction pad;
Fig. 3b shows a schematic cross-section of the SAR reduction pad of Fig. 3a in an activated state;
Fig. 4a shows a schematic cross-section of yet another embodiment of a SAR reduction pad;
Fig. 4b shows a schematic cross-section of the SAR reduction pad of Fig. 4a in a partially activated state;
Fig. 5 shows a schematic cross-section of yet another embodiment of a SAR reduction pad;
Fig. 6 shows a schematic top view of yet another embodiment of a SAR reduction pad;
Fig. 7 shows a schematic top view of yet another embodiment of SAR reduction pads;
Fig. 8 shows a schematic cross-section through a bore of an embodiment of an MRI system;
Fig. 9 shows a schematic cross-section through a bore of another embodiment of an MRI system;
Fig. 10a shows a schematic cross-section through a cable with a SAR reduction pad;
Fig. 10b shows a schematic cross-section through the cable of Fig. 10a with the SAR reduction pad in an activated state;
Fig. 11 shows a schematic cross-section through yet another embodiment of an MRI system;
Fig. 12 shows an example of a placement of SAR reduction pads on a patient; and
Fig. 13 shows a schematic chart of yet another embodiment of an MRI system.

### DETAILED DESCRIPTION OF EMBODIMENTS

Like numbered elements in these figures are either equivalent elements or perform the same function. Elements which have been discussed previously will not necessarily be discussed in later figures if the function is equivalent.

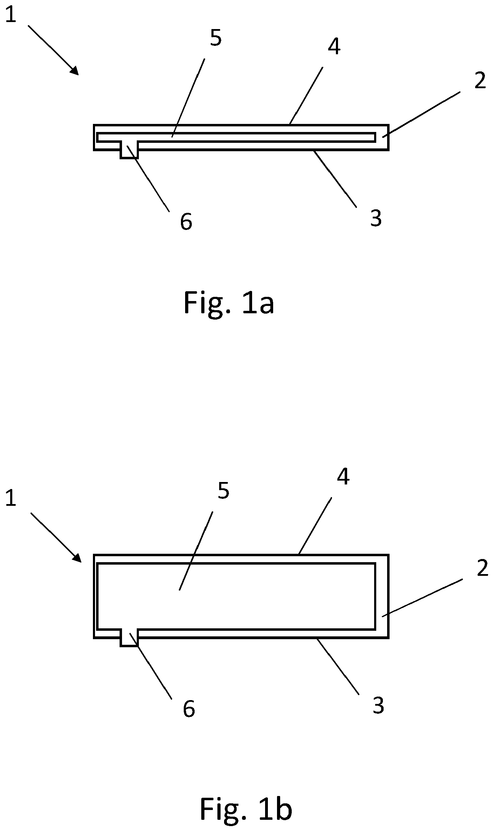

Fig. 1a shows a schematic cross-section of a specific absorption rate (SAR) reduction pad 1, comprising a pad body 2, a first surface 3 that is arranged on one side of the pad body 2 and a second surface 4 that is arranged on another side of the pad body 2, opposite to the first surface 3. The SAR reduction pad 1 further comprises chamber 5 that acts as a distance generation means. Said chamber 5 is in fluid connection with an fluid inlet 6 through which a fluid, in particular a gas such as air or nitrogen or a liquid, can enter the chamber 5 to inflate the chamber 5. When the chamber is inflated, as shown in Fig 1b, the distance between the first surface and the second surface is increased. Said increase in distance can move a patient's body, in particular the patient's skin away from a location with locally strong electromagnetic (EM) fields and/or from a location with hot parts, both of which can lead to overheating and/or burns of the patient's tissue.

In another embodiment (not shown here), the SAR reduction pads 1 may comprise flexible foam that includes a plurality of air chambers. Said flexible foam may be further combined with artificial metamaterial such that, e.g., alternating layers of foam and metamaterial are combined.

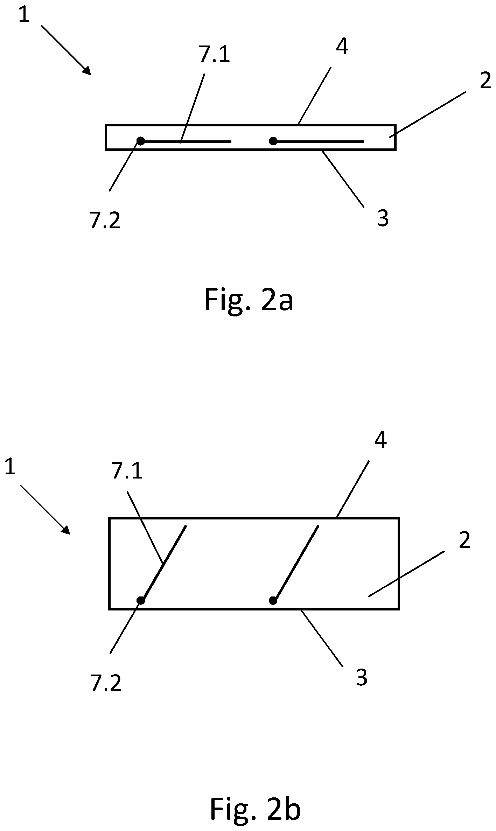

Fig 2a shows a schematic cross-section of another embodiment of a SAR reduction pad 1. Instead of the inflatable chamber 5 of the previous embodiment, this SAR reduction pad 1 comprises a mechanical distance generator 7 comprising plates 7.1 that are hinged at hinges 7.2 close to the first surface 3. The plates 7.1 may be erected as is shown in Fig 2b, e.g., by actuating a small electric motor or by pulling a wire that is connected to the plates 7.1 at a distance away from the hinges 7.2 (neither option is shown here). Again, by erecting the plates 7.1, the distance between the first surface 3 and the second surface 4 increases.

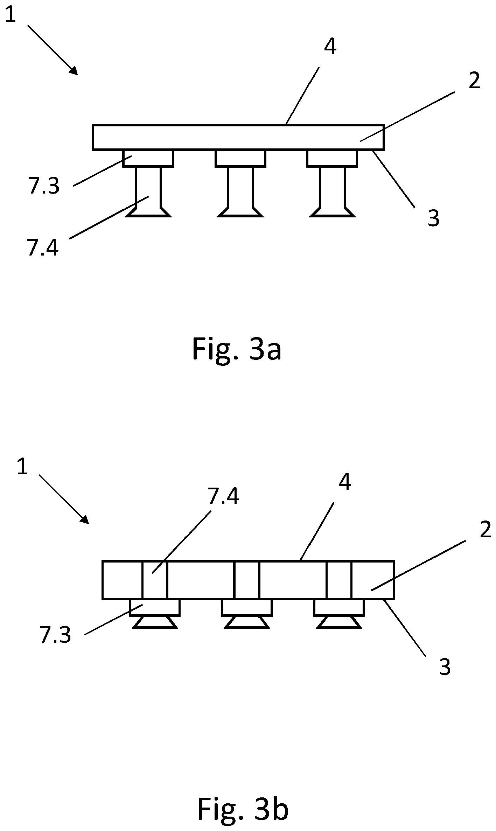

Fig 3a shows a schematic cross-section of yet another embodiment of a SAR reduction pad 1. Again, this SAR reduction pad comprises a mechanical distance generator 7, comprising screw nuts 7.3 that are fixed to the first surface 3 and screws 7.4 that are partially screwed into the screw nuts 7.3. By further screwing the screws 7.4, the tips of the screws 7.4 touch the second surface 4 and move the second surface 4 away from the first surface 3, as shown in Fig 3b. Again, this increases the distance between the first surface 3 and the second surface 4.

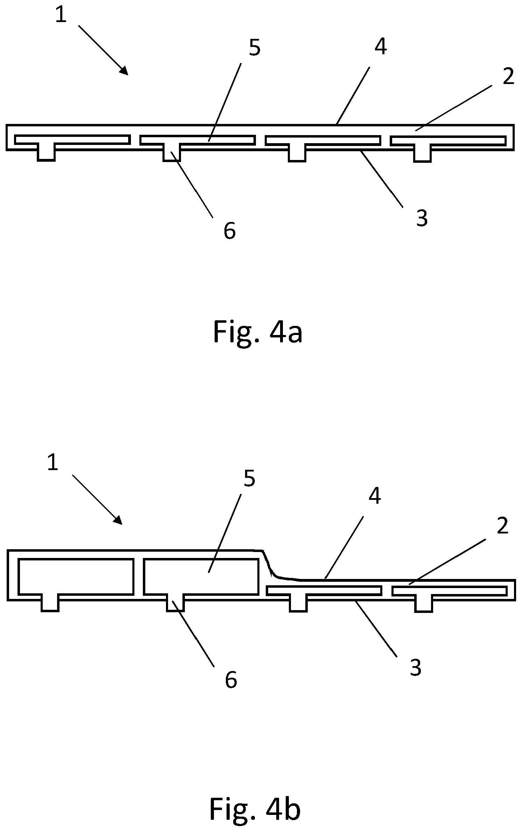

Fig 4a shows a schematic cross-section of yet another embodiment of a SAR reduction pad 1. This SAR reduction pad 1 comprises four chambers 5, however, other numbers of chambers are also possible. There are also four fluid inlets 6, wherein each of the fluid inlets 6 is in fluid connection with one of the chambers 5. In order to provide the best compromise between available free space and freedom to arrange a scan configuration on one hand and overheating and/or burn protection on the other hand, the chambers 5 can be inflated separately, as shown in Fig 4b, where only the two left chambers 5 have been inflated and the two right chambers 5 stay in a deflated state.

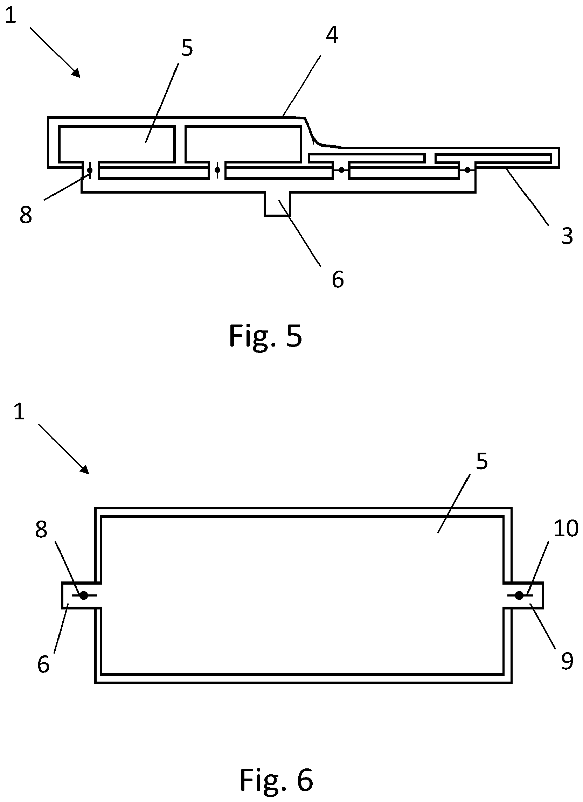

Fig 5 shows a schematic cross-section of yet another embodiment of a SAR reduction pad 1. This SAR reduction pad 1 also comprises four chambers 5. The chambers 5 are in fluid connection with a common fluid inlet 6 and there are valves 8 arranged between the fluid inlet 6 and the separate chambers 5. Hence, the separate chambers 5 can be individually inflated by opening and/or closing the respective valves 8.

Fig 6 shows a schematic top view of yet another embodiment of a SAR reduction pad 1. In addition to the fluid inlet 6, this SAR reduction pad 1 comprises a fluid outlet 9 that is also, via a valve 10, in fluid connection with the chamber 5. Hence, by adjusting the positions of the valves 8 and 10, in particular by opening them, closing them and/or leaving them partially open, both the degree of inflation of the chamber 5 and a flow of the fluid through the chamber 5 can be controlled. The flow of the fluid can provide additional cooling to the patient's skin. Other possible shapes of the chamber 5 in top view (not shown here) are U-shapes or toroidal shapes. Also, as another possible embodiment, a part of the SAR reduction pad 1 may have a fixed distance between the first surface 3 and the second surface 4 with, e.g., a foam structure in between the first surface 3 and the second surface 4, whereas another part of the SAR reduction pad 1 comprises at least one chamber 5 that allows an increase of the distance between the first surface 3 and the second surface 4.

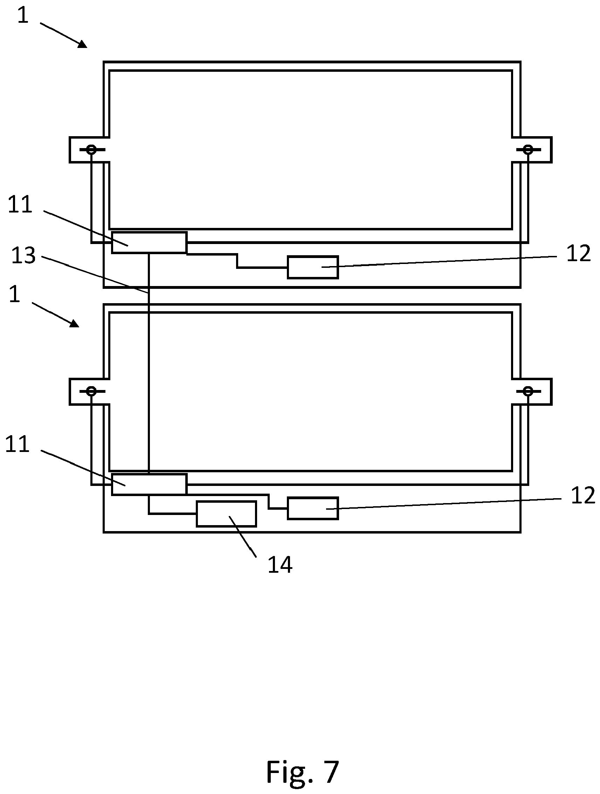

Fig 7 shows a schematic top view of yet another embodiment of SAR reduction pads 1. The SAR reduction pads 1 each comprise a microcontroller 11 that is connected to the valves 8 and 10 and is adapted to control the valves 8 and 10. Further, the SAR reduction pads 1 each comprise at least one sensor 12. This sensor 12 may be a pressure sensor, sensing the mechanical pressure exerted on the SAR reduction pad 1, an electromagnetic (EM) field sensor, sensing electromagnetic fields and, in particular, the strength thereof, and/or a temperature sensor, sensing the temperature at the SAR reduction pad 1. The sensor 12 is also connected to the microcontroller 11 to provide sensor readings to the microcontroller 11. The microcontrollers 11 of the SAR reduction pads 1 are connected to one another via an interconnect device 13, which may be an electrical cable or an optical fiber. The interconnect device may be used to transfer sensor readings and control signals for the valves between the microcontrollers 11 In some embodiments, the interconnect device 13 may further comprise a spacer to provide a predetermined distance between the separate SAR reduction pads 1. One of the SAR reduction pads 1 further comprises a wireless transceiver 14 that is also connected to the respective microcontroller 11. Sensor readings that are collected by said microcontroller 11, either directly from the sensor 12 associated with the microcontroller 11, or via the microcontroller 11 of the other SAR reduction pad 1, may be wirelessly sent to a computing unit of an MRI system via the wireless transceiver 14. Also, control data for the distance generation means, in this example control data for the valves 8 and 10, may be received wirelessly by the wireless transceiver 14 and then sent to the valves 8 and 10, either directly or via the microcontroller 11 of the other SAR reduction pad 1.

In an alternative embodiment (not shown here), the SAR reduction pad 1 may even comprise a part of a computing unit, in particular a computing unit comprising an artificial intelligence system. Then, the sensor readings may be directly sent to the part of the computing unit contained in the respective SAR reduction pad 1 and the part of the computing unit contained in the respective SAR reduction pad 1 may locally generate control data, e.g., to activate the distance generation means. If the computing unit comprises an artificial intelligence system such as an artificial neural network, even decision making of complex tasks, where threshold values and manually determined logic or rules may be not appropriate, can be realized.

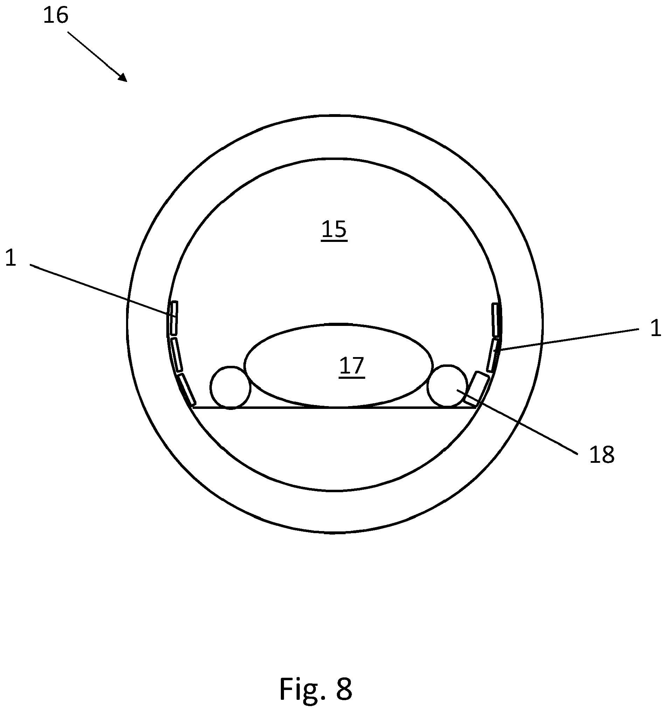

Fig 8 shows a schematic cross-section through a bore 15 of an MRI system 16. A patient 17 to be examined is placed inside the bore 15. Further, SAR reduction pads 1 are attached to the inner side walls of the bore 15, e.g., with screws, hooks, velcro or snap fasteners. At one position, the patient's arm 18 is close to or in contact to the side wall of the bore 15. This may be determined either by evaluation of camera images taken of the patient 17 inside the bore 15 or by readings of a pressure sensor, in particular a pressure sensor 12 of the SAR reduction pad 1. In order to protect the skin and/or tissue of the patient 17 from overheating and/or burns, the distance generation means of the SAR reduction pad 1 where the patient's arm 18 is close to or in contact with the side wall of the bore 15, has been activated, moving the patient's arm 18 away from the side wall of the bore 15.

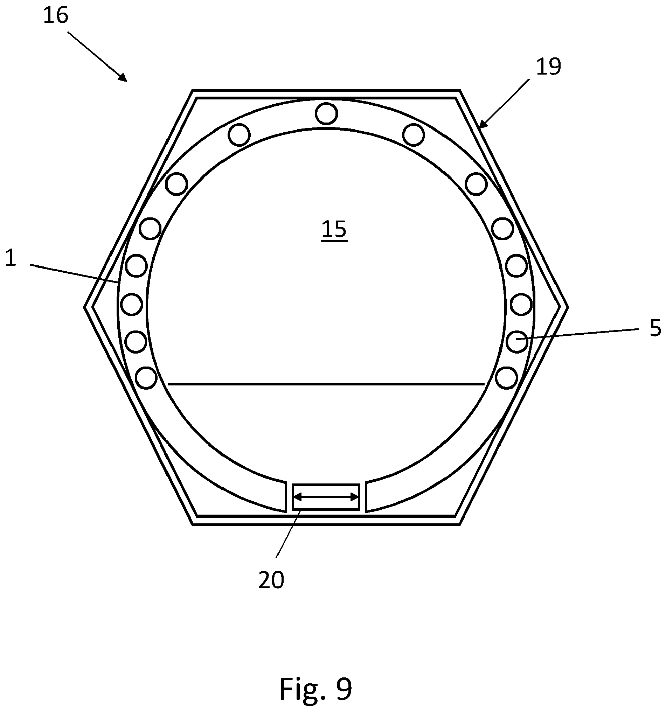

Fig 9 shows a schematic cross-section through a bore 15 of another embodiment of an MRI system 16. In this embodiment, solid bore walls have been completely omitted. Instead, a frame construction 19 provides stability for the bore 15 of the MRI system 16 and a SAR reduction pad 1 with a plurality of chambers 5 is placed inside the frame construction 19. In the shown embodiment, a stretching mechanism 20 forces the SAR reduction pad 1 to the outside such that it is securely fixed inside the frame construction 19. Said stretching mechanism 20 may be actuated, e.g., hydraulically, pneumatically or mechanically. However, other ways of fixing the SAR reduction pad 1 to the frame construction 19 can be used, too. As long as the chambers 5 of the SAR reduction pad 1 are deflated, a thin wall of the bore 15 is provided. In order to protect the patient's skin and/or tissue from overheating and/or burns, however, the chambers 5 may be inflated.

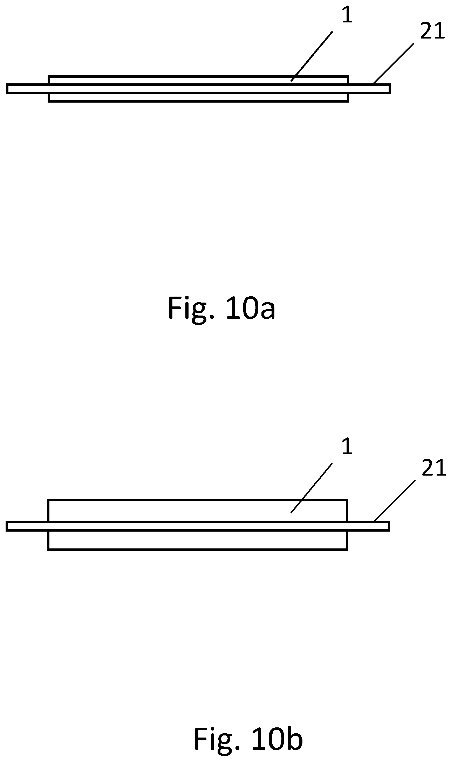

Fig 10a shows a cross-section through a cable 21 around which an SAR reduction pad 1 has been arranged. The cable 21 may, for example, be a feeding cable for a coil that is positioned on a patient 17. When a risk for overheating and/or burns of the patient's skin and/or tissue has been identified, the distance generation means of the SAR reduction pad 1 are activated, as shown in Fig 10b, moving the cable 21 further away from the patient 17 and protecting the patient 17 from local overheating and/or burns.

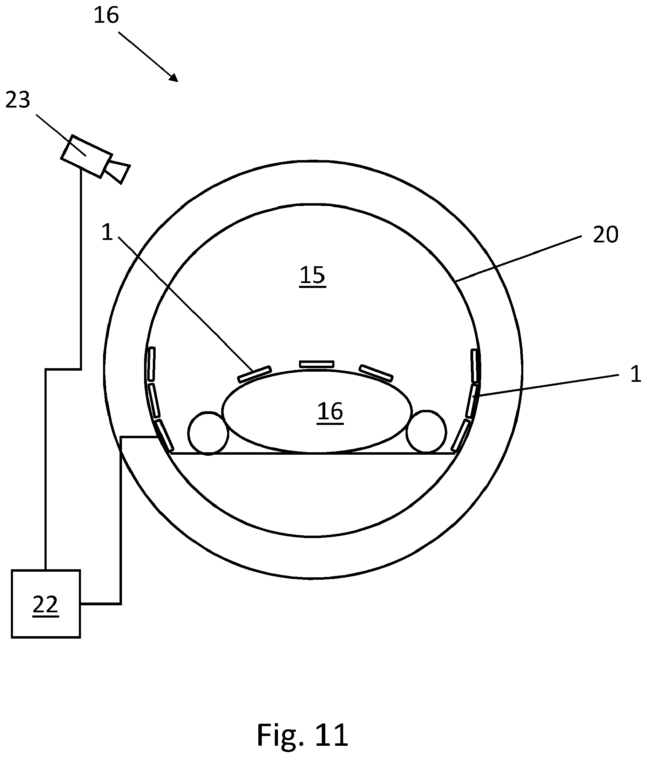

Fig 11 shows a cross-section through yet another embodiment of an MRI system 16. SAR reduction pads 1 are attached both to the side walls of the bore 15 and are placed on the patient 17, e.g., attached to clothes worn by the patient 17. Further, the MRI system 16 comprises a computing unit 22 and a camera 23. The camera 23 is connected to the computing unit 22, such that the computing unit 22 may receive images taken by the camera. Also, the SAR reduction pads 1 are connected to the computing unit 22, such that both sensor readings taken by the sensors 12 of the SAR reduction pads 1 can be transferred to the computing unit 22 and control instructions for controlling the distance generation means can be sent by the computing unit 22 to the SAR reduction pads 1. While a wired or optical connection between the computing unit 22 and the SAR reduction pads 1 is shown, also a wireless connection is possible. The computing unit 22 determines, based on the images taken by the camera 23 and/or the sensor readings, potential overheating of the patient's 17 tissue and activates the distance generation means of the SAR reduction pads 1 in order to prevent such overheating.

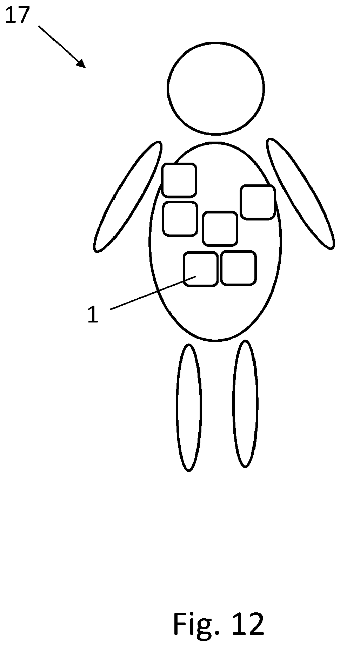

Fig 12 shows an example of a placement of SAR reductions pads 1 on a patient 17. In order to determine such a placement, the computing unit 22 of the MRI system 16 may obtain data from a lidar unit, a radar unit and/or an optical positioning detection unit, comprising at least two cameras. Based on said data as well as on patient characteristics such as age, size, weight and/or sedation status and on details of the MRI scans to be performed, the computing unit 22 determines the optimal placement of the SAR reduction pads 1. Said placement may be depicted on a display of a user interface in a similar way to the example shown in Fig 12. Then, a user may place the SAR reduction pads 1 on the patient 17 according to the placement determined by the computing unit 22. This may be performed by a user with ordinary skills, and highly trained operator staff is no longer needed.

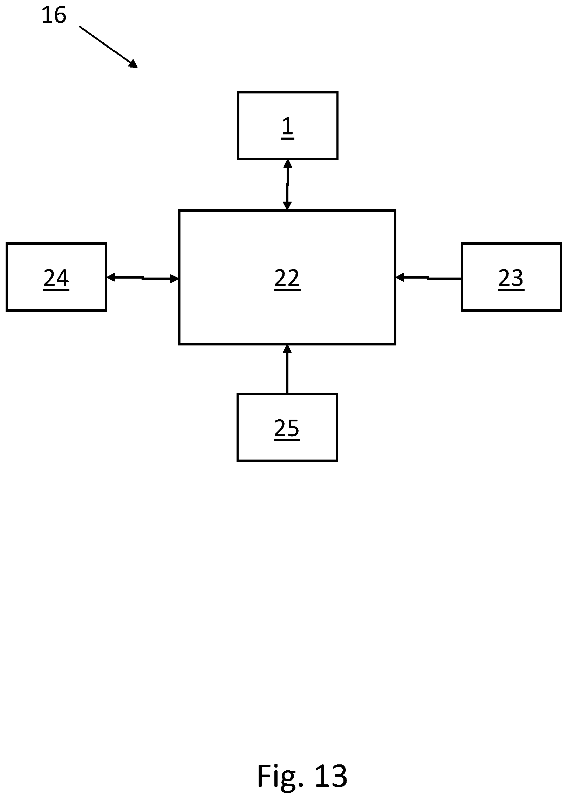

Fig 13 shows a schematic chart of yet another embodiment of an MRI system 16. The computing unit 22 is connected to an MRI scanner 24 of the MRI system 16, to SAR reduction pads 1, to a camera 23 and to a patient information database 25. The MRI scanner 24 may provide information on the scheduled MRI scan sequence to the computing unit 22. The SAR reduction pads 1 may be, for example, attached to the side walls of the bore 15 or may be individually placed on the patient 17. Instead of, or in addition to, the camera 23, a radar unit, a lidar unit and/or an optical positioning detection unit may provide information to the computing unit 22. The patient information database 25 may contain information on the patient 17 such as age, size, weight and/or sedation status. Further, the computing unit 22 may obtain information on coil placement and/or cable routing. Based on some or all of the provided information, the computing unit 22 may determine an optimal placement of the individually configurable SAR reduction pads 1, in particular of the SAR reduction pads 1 that are to be placed on the patient 17. Placement instructions for said determined placement may then be presented to a user via a user interface, e.g., on a display. Additionally, or alternatively, the computing unit 22 may selectively activate the distance generation means of the SAR reductions pads 1 based on some or all of the provided information. Also, the computing unit 22 may modify an MRI scan sequence and/or stop an MRI scan if it determines that the activation of the SAR reduction pads 1 is not sufficient to protect the patient's 17 skin and/or tissue from local overheating and/or burns. Further, the computing unit 22 may issue an alert, e.g., a nurse call, when it determines unusual patient behavior. The data obtained by the computing unit 22 may also be saved for further analysis, in particular for off-line analysis to further improve the MRI system 16.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. Any reference signs in the claims should not be construed as limiting the scope.

### LIST OF REFERENCE SIGNS:

- 1: SAR reduction pad
- 2: pad body
- 3: first surface
- 4: second surface
- 5: chamber
- 6: fluid inlet
- 7: mechanical distance generator
- 7.1: plate
- 7.2: hinge
- 7.3: screw nut
- 7.4: screw
- 8: valve
- 9: fluid outlet
- 10: valve
- 11: microcontroller
- 12: sensor
- 13: interconnect device
- 14: wireless transceiver
- 15: bore
- 16: MRI system
- 17: patient
- 18: arm
- 19: frame construction
- 20: stretching mechanism
- 21: cable
- 22: computing unit
- 23: camera
- 24: MRI scanner
- 25: patient information database

## Claims

1. Specific absorption rate, SAR, reduction pad (1), comprising
a pad body (2);
a first surface (3), arranged on one side of the pad body (2);
a second surface (4), arranged on another side of the pad body (2), opposite to the first surface (3); and
distance generation means (5, 6; 7) to increase a distance between the first surface (3) and the second surface (4).

2. SAR reduction pad (1) according to claim 1, wherein the distance generation means (5, 6; 7) comprise at least one chamber (5) to be filled with a fluid, and at least one fluid inlet (6) in fluid connection with the at least one chamber (5).

3. SAR reduction pad (1) according to claim 2, wherein the distance generation means (5, 6; 7) further comprise at least one valve (8) arranged between the at least one fluid inlet (6) and the at least one chamber (5).

4. SAR reduction pad (1) according to claim 2 or 3, wherein the distance generation means (5, 6; 7) further comprise at least one fluid outlet (9) in fluid connection with the at least one chamber (5) for circulating the fluid through the at least one chamber (5).

5. SAR reduction pad (1) according to any of claims 1 to 4, wherein the distance generation means (5, 6; 7) comprise at least one mechanical distance generator (7).

6. SAR reduction pad (1) according to any of claims 1 to 5, wherein the SAR reduction pad (1) further comprises at least one sensor (12), in particular a pressure sensor, an electromagnetic field sensor and/or a temperature sensor.

7. SAR reduction pad (1) according to any of claims 1 to 6, wherein the SAR reduction pad (1) further comprises an electrical, electronical, optical and/or wireless connector.

8. Magnetic resonance imaging, MRI, system (16), comprising
MRI electronics, including at least one of the following:
a transmitting coil for transmitting radio frequency, RF, signals;
a receiving coil for receiving RF signals;
a transmitting/receiving coil for transmitting and receiving RF signals;
cables (21); and
capacitors;
a computing unit (22); and
at least one specific absorption rate, SAR, reduction pad (1) according to any of claims 1 to 7.

9. MRI system (16) according to claim 8, wherein the at least one SAR reduction pad (1) is attached to a bore wall of the MRI system (16), in particular a side of the bore wall, constitutes at least a part of the bore wall of the MRI system (16), is placed on at least one part of the MRI electronics, in particular around a cable (21), and/or is attached to a patient (17).

10. MRI system (16) according to claim 8 or 9, wherein
the MRI system (16) further comprises a user interface; and
the computing unit (22) is configured to determine a placement of the SAR reduction pads (1) and provide SAR reduction pad (1) placement instructions via the user interface.

11. MRI system (16) according to any of claims 8 to 10, wherein the computing unit (22) is configured to selectively activate the distance generation means (5, 6; 7), in particular based on sensor readings.

12. MRI system (16) according to any of claims 8 to 11, wherein the computing unit (22) is configured to issue an alert, modify an MRI scan sequence and/or stop an MRI scan based on sensor readings.

13. MRI system (16) according to any of claims 8 to 12, where the computing unit (22) comprises an artificial intelligence system, in particular a trained machine learning system.

14. Method for operating a magnetic resonance imaging, MRI, system (16) according to any of claims 8 to 13, wherein
a placement of the SAR reduction pads (1) is determined by the computing unit (22);
the determined placement of the SAR reduction pads (1) is provided to a user via the user interface;
the SAR reduction pads (1) are placed by the user according to the determined placement of the SAR reduction pads (1); and
an MRI scan and/or MRI scan sequence is performed.

15. Method according to claim 14, wherein
sensor readings are obtained before and/or during the MRI scan and/or MRI scan sequence; and
the distance generation means (5, 6; 7) are selectively activated based on the obtained sensor readings.
